# EUROPEAN PATENT SPECIFICATION

(11) **EP 3 699 946 B1**
(45) Date of publication and mention of the grant of the patent: **09.10.2024**
(21) Application number: 18869340.2
(22) Date of filing: 28.09.2018
(51) Int. Cl.: H01J 27/20, C23C 14/48, H01J 37/08, H01J 37/317, H01L 21/265, H05H 1/24, H01J 27/08

(54) **ION SOURCE AND ION INJECTION DEVICE**
IONENQUELLE UND IONENINJEKTIONSVORRICHTUNG
SOURCE D'IONS ET DISPOSITIF D'INJECTION D'IONS

(30) Priority: 18.10.2017 JP 2017201641
(43) Date of publication of application: 26.08.2020
(73) Proprietor: ULVAC, Inc., Chigasaki-shi, Kanagawa 253-8543 (JP)
(72) Inventor: SASAKI, Naruyasu, Chigasaki-shi Kanagawa 253-8543 (JP); HIGASHI, Akio, Chigasaki-shi Kanagawa 253-8543 (JP); TERASAWA, Toshihiro, Chigasaki-shi Kanagawa 253-8543 (JP)
(74) Representative: Körber, Martin Hans
(86) International application number: PCT/JP2018/036195
(87) International publication number: WO 2019/077970

(56) References cited:
- CN-A- 105 448 630
- JP-A- 2010 080 429
- JP-A- 2011 124 059
- JP-A- 2015 170 451
- JP-A- 2015 170 451
- JP-A- H06 325 711
- US-A1- 2003 122 089
- MIYAMOTO N. ET AL: "Aluminum Ion Beam Production for Medium Current Implanter", AIP CONFERENCE PROCEEDINGS, 1 January 2011 (2011-01-01), NEW YORK, US, pages 384 - 387, XP055795907, ISSN: 0094-243X, Retrieved from the Internet <URL:https://aip.scitation.org/doi/pdf/10.1063/1.3548428> DOI: 10.1063/1.3548428

## Description

### Technical Field

The present invention relates to an ion source, and particularly to a technique regarding an ion source used for an ion implantation apparatus.

### Background Art

In recent years, a method for manufacturing a substrate of silicon carbide (SiC) that has better heat resistance and can better withstand voltage compared to an existing silicon (Si) substrate has been established, thereby making SiC substrates available at a relatively low cost.

A process using an SiC substrate includes a process of implanting an aluminum ion as a dopant, and an ion implantation apparatus that includes an ion source for generating an aluminum ion beam.

In the ion source as described above, as methods for generating an aluminum ion, there is a method in which aluminum chloride is heated to generate an aluminum ion. However, this method has low productivity. As such, , another method in which aluminum nitride and a fluorine-based gas are reacted with each other to generate the aluminum ion have been adopted.

However, even with the method in which aluminum nitride and a fluorine-based gas react with each other, there are problems in that aluminum fluoride (AlFₓ) is generated as an intermediate product, the generated aluminum fluoride is deposited within a reaction chamber, and generation of the aluminum ion is suspended.

For those reasons, conventional techniques suffer from a problem of a need for frequent maintenance of an ion source.

### Citation List

### Patent Literature

Patent Literature 1: JP 3325393 B2
Patent Literature 2: JP 4428467 B2
Further related art according to the preamble of claim 1 is e.g. disclosed in CN 105448630 A and US 2003/122 089 A1.

### Summary of Invention

### Technical Problem

It is an object of the present invention to provide a technique which allows for generation of an aluminum ion without deposition of an intermediate product in a reaction chamber.
The present invention is defined by the independent claims. Advantageous implementations are defined in the dependent claims.

### Solution to Problem

To solve the above-described problems associated with the conventional technique, the present embodiment provides an ion source comprising a cathode electrode arranged in one end of an inside of a chamber, a repeller electrode arranged in the other end of the inside of the chamber and facing a surface of the cathode electrode, a filament arranged on a back-surface side of the cathode electrode, a gas introduction hole to which a fluorine-compound gas is introduced, the gas introduction hole being provided in the chamber, and an emission hole through which a positively-charged ion is extracted out of the chamber, wherein a raw-material block is arranged in the chamber, the cathode electrode is heated by the filament through which a current is flowing, and a thermoelectron is emitted from an electron emitting surface of the surface of the cathode electrode toward the repeller electrode, the thermoelectron decomposing the fluorine-compound gas introduced through the gas introduction hole and generating plasma by reciprocally moving between the cathode electrode and the repeller electrode, and the positively-charged aluminum ion is generated by reaction of fluorine in the plasma with the raw-material block, the raw-material block is arranged near a side surface of the cathode electrode while being out of contact with the cathode electrode and the chamber, the raw-material block is aluminum nitride, the fluorine-compound gas is a phosphorus-trifluoride gas, and aluminum fluoride that is generated from the raw-material block and the fluorine-compound gas is decomposed by the thermoelectron so that an aluminum ion that is to be extracted out of the chamber is generated.

Also, the present embodiment provides the ion source, wherein the fluorine-compound gas is converted into the plasma by the thermoelectron, and an evaporation surface of the raw-material block, which is facing the repeller electrode and contacts the plasma, is located between a surface of the repeller electrode which is facing the cathode electrode and the electron emitting surface, and is located in such a position that a distance between a flat surface in which the evaporation surface is included and the electron emitting surface is smaller than a distance between the flat surface that includes the evaporation surface and a surface of the repeller electrode, the surface of the repeller electrode facing the electron emitting surface.

Also, the present embodiment provides the ion source, wherein the raw-material block is heated to a temperature in a range of 1200 °C to 1700 °C, by heat generation of the cathode electrode.

Also, according to the present invention, the raw-material block is arranged in a tip end of a raw-material supporting unit, a protruding portion that protrudes in an outward direction that is perpendicular to a side surface of the raw-material supporting unit is provided in the tip end of the raw-material supporting unit, the raw-material block is arranged on a surface of the protruding portion, the surface of the protruding portion facing the repeller electrode, and an attaching member is arranged on a back surface, and the raw-material block is hung from the attaching member with screws, and the protruding portion is pinched between the raw-material block and the attaching member so that the raw-material block is fixed to the raw-material supporting unit.

The present embodiment provides an ion implantation apparatus comprising an ion as described above, the ion implantation apparatus further comprising; an extraction electrode arranged adjacent to the emission hole, the extraction electrode being configured to extract the positively-charged ion in the chamber, a mass spectrometer configured to mass-analyze the ion extracted by the extraction electrode, and an implantation chamber in which a substrate being irradiated with the ion that is mass-analyzed is arranged.

### Advantageous Effects of Invention

According to the present invention, a long-lasting and durable ion source that can generate a large amount of aluminum ions, and an ion implantation apparatus which includes the foregoing ion source, can be provided. Also, aluminum ions can be implanted stably for a long time.

It is easy to replace the raw-material block.

### Brief Description of Drawings

Fig. 1 is a schematic configuration diagram showing a whole of one example of an ion implantation apparatus according to the present invention using an ion source according to the present invention.
Fig. 2 is a sectional view showing an example of a configuration of the ion source according to the present invention.
Fig. 3 is a view for explaining a positional relationship between a raw-material block and a raw-material supporting unit.
Fig. 4 (a) is a plan view of the raw-material block, Fig. 4(b) is a plan view of an attaching member, and Fig. 4(c) is a side view of the raw-material supporting unit.
Fig. 5 is a graph showing a relationship between a temperature of aluminum nitride and a partial pressure of a nitrogen gas (N₂) being emitted.
Fig. 6 includes photographs each showing a state in which byproducts are accumulated within a chamber, and Fig. 6(a) shows a case where a boron-trifluoride gas is used while Fig. 6(b) shows a case where a phosphorus-trifluoride is used.

### Description of Embodiments

Hereinbelow, an embodiment of the present invention will be described with reference to the drawings.

### <Ion implantation apparatus>

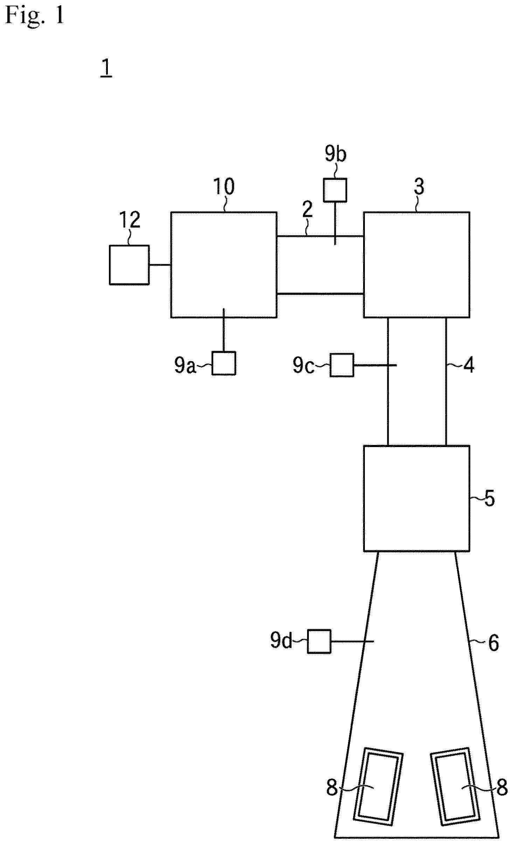

Fig. 1 is a schematic configuration diagram showing a whole of an ion implantation apparatus 1 according to the present invention using an ion source according to the present invention.

As shown in Fig. 1, the ion implantation apparatus 1 of the present example includes an ion source 10, which will be later described, a travel chamber 2, a mass spectrometer 3, an accelerator 4, a scanning device 5, and an implantation chamber 6, which are connected in this order.

It is noted that the ion implantation apparatus 1 is configured so that the ion source 10, the travel chamber 2, the accelerator 4, and the implantation chamber 6 are evacuated by evacuation devices 9a to 9d, respectively.

The ion source 10 is connected with a gas supply unit 12 and generates an ion by using a gas supplied from the gas supply unit 12, and a positively-charged ion is extracted in the travel chamber 2, travels within the travel chamber 2, and then enters into the mass spectrometer 3.

A positively-charged ion is mass-analyzed while it is passing through the inside of the mass spectrometer 3, and an ion having a desired mass-to-charge ratio passes through the mass spectrometer 3 and enters into the accelerator 4.

Here, an aluminum ion passes and enters into the accelerator 4.

In the accelerator 4, the aluminum ion which has entered into the accelerator 4 is accelerated and, when it enters into the scanning device 5, the resulting ion beam is controlled by the scanning device 5 with respect to a direction of travel of the ion beam, and the ion beam enters into the implantation chamber 6.

A plurality of (two in this example) substrates 8 are arranged in the implantation chamber 6. The ion beam is directed toward a certain substrate out of the plurality of substrates 8 by the above-described scanning device 5 and is irradiated on a surface of the certain substrate. A surface of the substrate 8 is scanned by an ion beam, and the ion is implanted.

### <Ion source>

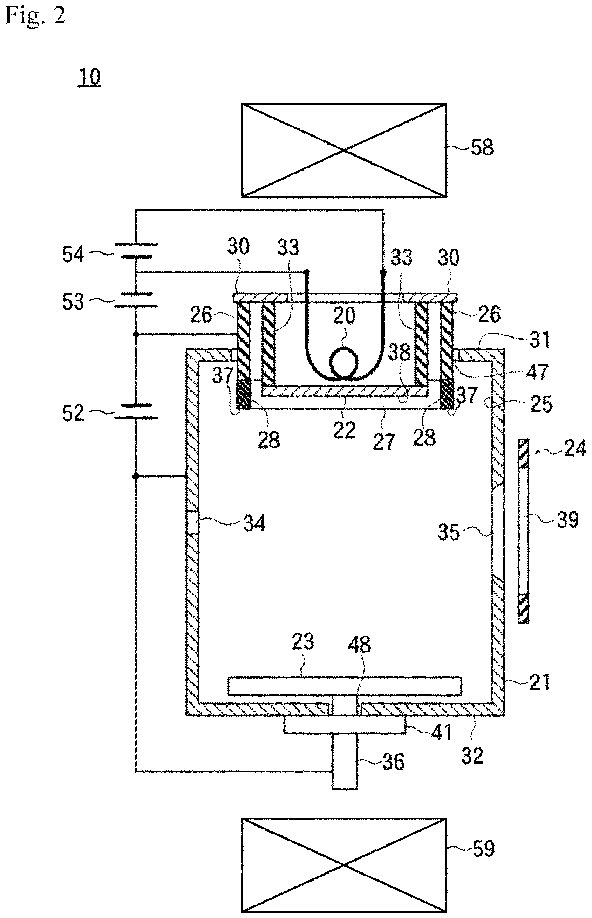

Fig. 2 is a view for explaining the inside of the ion source 10 according to the present invention. In the ion source 10, a chamber 21 having a shape of a tube (a rectangular tube in this example) is arranged, and the inside of the chamber 21 is evacuated by the evacuation device 9a shown in Fig. 1 to create a vacuum environment.

The chamber 21 includes two bottom surfaces 31 and 32. One bottom surface 31 is located in one end of the chamber 21 while the other bottom surface 32 is located in the other end of the chamber 21, and the bottom surfaces 31 and 32 are provided with mounting holes 47 and 48, respectively. In the chamber 21, a filament 20 is arranged in a position close to the one bottom surface 31, and a repeller electrode 23 is placed in a position close to the other bottom surface 32. The filament 20 is arranged in the vacuum environment outside the chamber 21.

Inside the chamber 21, between the filament 20 and the repeller electrode 23, a cathode electrode 22 is arranged in a position close to the filament 20. Accordingly, the cathode electrode 22 is arranged on a side where the one bottom surface is provided, and the repeller electrode 23 is placed on a side where the other bottom surface is provided. Each of the cathode electrode 22 and the repeller electrode 23 has a shape of a flat plate or a column, respective surfaces which face each other are made parallel to each other, and the filament 20 is arranged on a back side of the cathode electrode 22.

Outside of the chamber 21, a base plate 30 is arranged near the bottom surface 31 close to the filament 20. The base plate 30 is fixed to the chamber 21 in a state of being insulated.

A raw-material supporting unit 26 and an electrode supporting unit 33 are inserted through the mounting hole 47 of the bottom surface 31 close to the filament 20, then a tip end of the electrode supporting unit 33 which is one end of the electrode supporting unit 33 is placed within the chamber 21, and a base portion of the electrode supporting unit 33 which is the other end of the electrode supporting unit 33 is fixed to the base plate 30. The cathode electrode 22 is mounted onto the tip end of the electrode supporting unit 33 by a structure not shown in the drawings. It is noted that the electrode supporting unit 33 and the cathode electrode 22 may be incorporated into an integral structure.

A supporting rod 36 is inserted into the mounting hole 48 in the bottom surface 32 which is located relatively far from the filament 20. A tip end of the supporting rod 36 is arranged within the chamber 21, and the repeller electrode 23 is fixed to the tip end of the supporting rod 36.

The supporting rod 36 has electrical conductivity, and a portion of the supporting rod 36, whose portion is on a side opposite to a tip end, is arranged outside the chamber 21.

The supporting rod 36 is fixed to the chamber 21 by an insulator 41, and the supporting rod 36 and the chamber 21 are insulated from each other.

The raw-material supporting unit 26 is arranged between an edge of the mounting hole 47 and the electrode supporting unit 33 while being out of contact with the chamber 21 and the electrode supporting unit 33.

A base of the raw-material supporting unit 26 is fixed to the base plate 30, and a raw-material block 28 formed of a solid aluminum compound which is molded into a predetermined shape is attached to a tip end of the raw-material supporting unit 26. In this example, an aluminum compound is aluminum nitride (AlN).

The electrode supporting unit 33 and the raw-material supporting unit 26 have electrical conductivity and are at the same potential as the base plate 30, so that the cathode electrode 22 and the raw-material block 28 are also at the same potential as the base plate 30.

The raw-material block 28 is arranged between a side surface of the cathode electrode 22 and a side surface 25 of the chamber 21 while being out of contact with both of the cathode electrode 22 and the chamber 21, and an evaporation surface 37 which is one surface out of surfaces of a plurality of the raw-material block 28. The one surface facing the repeller electrode 23, which is spaced from the raw-material block 28, is made flat and is made parallel to respective surfaces of the cathode electrode 22 and the repeller electrode 23 which are made parallel to each other.

Assuming that a surface of the cathode electrode 22, i.e., the surface facing the repeller electrode 23, is referred to as an electron emitting surface 38, a flat surface where the evaporation surface 37 is included is located between a surface of the repeller electrode 23, i.e., the surface facing the cathode electrode 22, and the electron emitting surface 38. In other words, the evaporation surface 37 is arranged in such a position so as to make a distance between a flat surface where the evaporation surface is included and the repeller electrode 23 smaller than a distance between the electron emitting surface 38 and the repeller electrode 23. Also, the evaporation surface 37 is arranged in such a position so as to make a distance between a flat surface where the evaporation surface 37 is included and the electron emitting surface 38 smaller than a distance between a flat surface where the evaporation surface 37 is included and the repeller electrode 23.

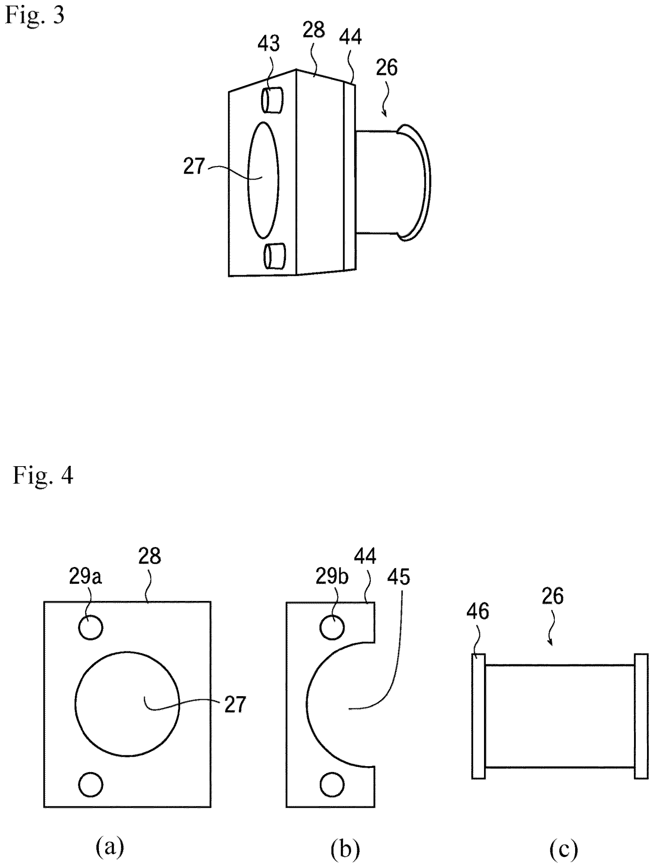

Fig. 4(a) is a plan view of the raw-material block 28. As shown in Fig. 4(a), the raw-material block 28 has a ring shape with a window hole 27 formed in a center of a metal body, and the electron emitting surface 38 of the cathode electrode 22 is arranged in the window hole 27 formed in the center, so that the emitting surface 38 is exposed in the window hole 27.

In the present example, the window hole 27 has a circular shape, the cathode electrode 22 has a shape of a disk, and the design is such that a diameter of the window hole 27 is larger than a diameter of the cathode electrode 22.

A discharge power supply 52, a cathode-heating power supply 53, and a filament-heating power supply 54 are arranged outside the chamber 21.

Apositive-voltage terminal of the discharge power supply 52 is electrically connected to the chamber 21.

Anegative-voltage terminal of the discharge power supply 52 is electrically connected to the base plate 30. Here, electrical connection is established via the raw-material supporting unit 26. Accordingly, when the discharge power supply 52 operates, a negative voltage with respect to the chamber 21 is applied to each of the cathode electrode 22 and the raw-material block 28.

Also, a negative-voltage terminal of the discharge power supply 52 is electrically connected to a positive-voltage terminal of the cathode-heating power supply 53, and a negative-voltage terminal of the cathode-heating power supply 53 is electrically connected to one end of the filament 20. When the cathode-heating power supply 53 operates, a negative voltage with respect to the cathode electrode 22 is applied to the filament 20.

Also, one end of the filament 20 is electrically connected to a negative-voltage terminal of the cathode-heating power supply 53 and a negative-voltage terminal of the filament-heating power supply 54, and the other end of the filament 20 is electrically connected to a positive-voltage terminal of the filament-heating power supply 54.

The cathode electrode 22, the repeller electrode 23, and the filament 20 are arranged in a vacuum environment, and heat is generated when the filament-heating power supply 54 operates and a current is flowing through the filament 20 in the vacuum environment.

In the foregoing state, while a negative voltage with respect to the cathode electrode 22 is being applied to the filament 20 by the cathode-heating power supply 53, a thermoelectron is emitted from the filament 20 toward the cathode electrode 22, and when the thermoelectron collides with the cathode electrode 22, the cathode electrode 22 is heated.

In a state where a negative voltage with respect to the chamber 21 is being applied to the cathode electrode 22 by the discharge power supply 52, when the cathode electrode 22 is heated, a thermoelectron is emitted from the exposed electron emitting surface 38 of the cathode electrode 22 toward the repeller electrode 23, and is accelerated.

The repeller electrode 23, which is at a floating potential, is at the same negative potential as the cathode electrode 22, and a thermoelectron which is emitted from the cathode electrode 22 and is accelerated (this thermoelectron will hereinafter be referred to as a primary electron) flies toward the cathode electrode 22 as a direction of flight thereof is reversed by electrostatic force.

Also, the primary electron which travels toward the cathode electrode 22 is reversed toward the repeller electrode 23 as a direction of flight thereof is reversed by the cathode electrode 22.

In the above-described manner, a primary electron reciprocally moves between the cathode electrode 22 and the repeller electrode 23.

Outside the chamber 21, a magnet 58 in which one of two magnetic poles of the north pole and the south pole is directed toward the chamber 21, and a magnet 59 in which the other pole is directed toward the chamber 21, are arranged, and magnetic lines formed between the north pole and the south pole are designed so as to penetrate the cathode electrode 22 and the repeller electrode 23.

Accordingly, the primary electron reciprocally moves while spirally moving by winding around magnetic lines. By the above-described actions, the probability of collision between a gas and an electron in the chamber 21 is increased in an attempt to increase an efficiency of producing plasma.

In a side surface of the chamber 21, a gas introduction hole 34 and an ion emission hole 35 are provided.

The gas introduction hole 34 is connected to the gas supply unit 12, and when a fluorine-compound gas is supplied from the gas supply unit 12, a fluorine-compound gas is decomposed by the primary electron which reciprocally moves in the chamber 21, so that a fluorine ion or a fluorine radical is generated.

The cathode electrode 22 is formed of high-melting-point metal, and is heated to a temperature of about 2200 °C by the filament 20.

The raw-material block 28 is arranged near the cathode electrode 22 while being out of contact with the cathode electrode 22, and the raw-material block 28 is arranged while being out of contact with the chamber 21.

Accordingly, the raw-material block 28 is heated by heat rays emitted from the cathode electrode 22 in order not to flow out heat to chamber 21, and a temperature is increased.

As described above, among surfaces of the raw-material block 28, the evaporation surface 37 facing the repeller electrode 23, which is spaced from the raw-material block 28, is arranged in a position which is closer to the repeller electrode 23 than the electron emitting surface 38, and the raw-material block 28 is configured such that the raw-material block 28 is heated to a temperature in a range of 1200 °C to 1700 °C by means of adjusting a temperature of the cathode electrode 22, and adjusting a distance between the evaporation surface 37 of the raw-material block 28, the evaporation surface 37 being facing the repeller electrode 23, and the electron emitting surface 38. The distance is in a direction perpendicular to the electron emitting surface 38, a distance between the raw-material block 28 and a side surface of the cathode electrode 22, and a distance between the raw-material block 28 and an inner side surface of the chamber 21.

Plasma containing a fluorine ion or a fluorine radical is generated from a fluorine-compound gas introduced into the chamber 21 by the primary electron, and the evaporation surface 37 comes into contact with generated plasma. Plasma comes into contact with aluminum nitride exposed in the evaporation surface 37, and aluminum nitride reacts with fluorine such as a fluorine ion or a fluorine radical in plasma, so that aluminum fluoride (AlFₓ) is generated.

Aluminum fluoride changes to a gas by being heated to a high temperature, and is emitted to the inside of the chamber 21 from the raw-material block 28. Since aluminum fluoride gas is generated in the heated chamber 21, aluminum fluoride does not precipitate in an inside of the pipe connected with the chamber 21.

Aluminum fluoride which is emitted is decomposed by the primary electron reciprocally moving in the chamber 21, so that an aluminum ion (Al⁺) is generated.

An extraction electrode 24 shaped like a plate, to which a negative voltage with respect to the chamber 21 is applied, is placed in a position that is close to the ion emission hole 35 and that is outside the chamber 21,and a positively-charged ion generated in the chamber 21 is attracted toward the extraction electrode 24 by an electric field formed by the extraction electrode 24, is extracted out of the chamber 21 through the ion emission hole 35, and enters into the above-described travel chamber 2, passing through a hole 39 in the center of the extraction electrode 24. The aluminum ion is included among the positively-charged ions which enter into the travel chamber 2.

As the above-described fluorine-compound gas, a phosphorus-trifluoride (PF₃) gas or a boron-trifluoride (BF₃) gas can be used. In a case where a boron-trifluoride gas is used, boron nitride (BN), which has a high evaporation temperature, is generated as a byproduct, and boron nitride is accumulated in the chamber 21.

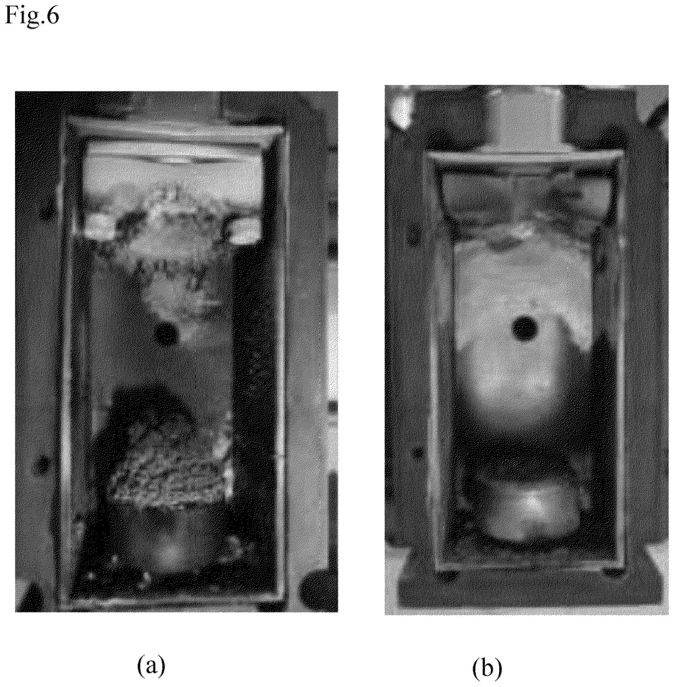

Fig. 6(a) is a photograph showing a state of byproducts in the chamber 21 in a case where a boron-trifluoride gas is used, and Fig. 6(b) is a photograph showing a state of byproducts in the chamber 21 in a case where a phosphorus-trifluoride gas is used. An amount of byproducts in the case where a phosphorus-trifluoride gas is used is relatively small.

While an aluminum ion can be generated by using a nitrogen-trifluoride (NF₃) gas, it is more advantageous to use a phosphorus-trifluoride gas because a nitrogen-trifluoride gas is lower in reactivity than a phosphorus-trifluoride gas.

In a case where alumina (Al₂O₃) is used for the raw-material block 28, production of aluminum ions is small. Moreover, it is more advantageous to use aluminum nitride in that no oxygen plasma is generated.

When alumina and a BF₃ gas are reacted with each other, a BO ion, which has the same mass-to-charge ratio as that of an aluminum ion, is generated, and thus, use of a combination of alumina and a BF₃ gas is discouraged.

The raw-material block 28 shouldbe heated to a temperature equal to or higher than 1200 °C at a minimum in order to emit a necessary amount of aluminum fluoride. A higher heating temperature is desirable, but nitrogen gas is also emitted together with emission of aluminum fluoride.

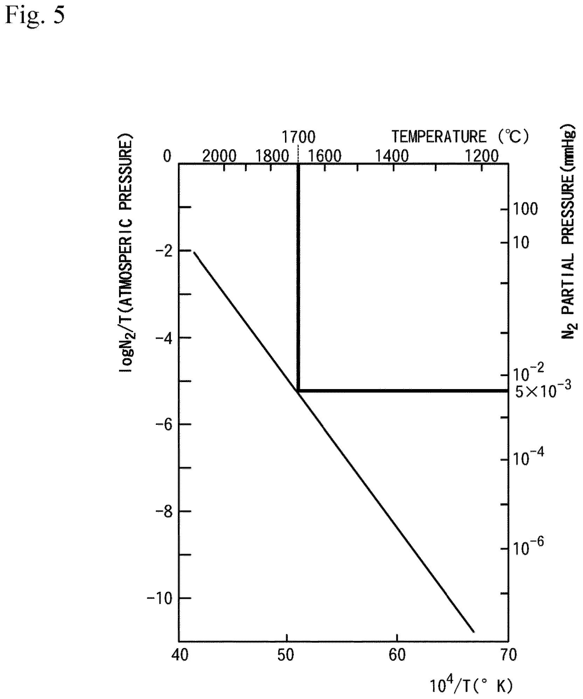

Fig. 5 is a graph showing a relationship between a temperature of aluminum nitride and a partial pressure of a nitrogen gas (N₂) emitted from aluminum nitride (see, "Shinku", Vol. 9 (1966), No. 5, pp. 183-189), and the graph indicates that an upper limit of a temperature of aluminum nitride is equal to 1700 °C because an upper limit of an operating pressure of an ion source is equal to approximately 5 × 10⁻³ mmHg.

Fig. 3 is a perspective view for explaining one example in which the raw-material block 28 is attached to the raw-material supporting unit 26, and Fig. 4(c) is a side view of the raw-material supporting unit 26.

Each of the electrode supporting unit 33 and the raw-material supporting unit 26 is a hollow cylinder in this example, and it is designed such that a diameter of the electrode supporting unit 33 is smaller than a diameter of the raw-material supporting unit 26 in this example.

The electrode supporting unit 33 and the raw-material supporting unit 26 are fixed to the base plate 30 with coinciding center axis lines and with the electrode supporting unit 33 being arranged in a hollow inner portion of the raw-material supporting unit 26.

A protruding portion 46 is provided in a tip end of the raw-material supporting unit 26. The protruding portion 46 protrudes in an outward direction perpendicular to a side surface of the raw-material supporting unit 26, and can be formed in a shape of a flange, for example. In Fig. 2, the protruding portion 46, an attaching member 44 and a screw 43, which will be later described, and the like are omitted.

As seen in Fig. 4(b) the attaching member 44 has a semicircular attaching hole 45 formed therein. The attaching hole 45 is formed such that a diameter of a semicircular shape thereof is equal to, or a little larger than, an outside diameter of the raw-material supporting unit 26. Accordingly, the attaching member 44 can be fitted to the raw-material supporting unit 26 so that the raw-material supporting unit 26 is located in the attaching hole 45.

The repeller electrode 23 is placed in a lower position in the chamber 21, the raw-material supporting unit 26 is arranged vertically so that the protruding portion 46 is located in a lower end of the raw-material supporting unit 26, and the raw-material supporting unit 26 is fixed to the chamber 21 in a state that electric insulation is kept between the raw-material supporting unit 26 and the chamber 21.

When the attaching member 44 is mounted on the raw-material supporting unit 26, the attaching member 44 is placed on the protruding portion 46.

An insertion hole 29a into which a screw can be inserted is formed in the raw-material block 28, and a screw hole 29b which has a screw groove formed in an inner surface thereof is provided in the attaching member 44.

The raw-material block 28 is brought into contact with a surface of the protruding portion 46, i.e., the surface facing the repeller electrode 23,while the protruding portion 46 is held between the raw-material block 28 and the attaching member 44. A screw 43 is inserted into the insertion hole 29a of the raw-material block 28, as shown in Fig. 3, and a tip end of the screw 43 is screwed into the screw hole 29b of the attaching member 44.

Then, the screw 43 is rotated to apply force in such a direction so as to bring the raw-material block 28 and the attaching member 44 close to each other, such that a screw head of the screw 43 is brought into contact with the raw-material block 28,the protruding portion 46 is pinched between the raw-material block 28 and the attaching member 44, and the raw-material block 28 is fixed to the raw-material supporting unit 26. At that time, because the raw-material block 28 is hung from the attaching member 44 with the screw 43, which is screwed and fixed to the attaching member 44, and the raw-material block 28 is screwed and fixed to the attaching member 44 with the screw 43, to be prevented from dropping off the raw-material supporting unit 26, the raw-material block 28 does not need to be pressed against the attaching member 44 by a thrust of the screw 43.

As the raw-material block 28 is consumed along with generation of ions, a surface pressure being pinched may be reduced because of consumption of the raw-material block 28, in some cases, even though the raw-material block 28 is fixed by a thrust of the screw 43. Nonetheless, under circumstances where an ion implantation apparatus is vibrating, a screw does not voluntarily rotate, so that a distance which is given at a time of initial fastening is kept unchanged. Accordingly, even if a portion of the raw-material block 28, the portion coming into contact with a flange of the screw 43, is consumed, an angle at which the protruding portion 46 is pinched is only slightly increased by weights of the raw-material block 28 and the attaching member 44, and the raw-material block 28 is prevented from dropping off.

For the above-described reasons, small fastening torque may be given to the screw 43 which is provided in order to pinch the protruding portion 46.

Small fastening torque results in suppression of thermal contact conduction between the raw-material block 28 and the raw-material supporting unit 26, so that an amount of heat which flows from the raw-material block 28 is reduced.

Also, small fastening torque facilitates an operation for attaching the raw-material block 28.

In the meantime, each of the attaching member 44 and the screw 43 is configured by a process in which a stainless-steel material is molded. When they are exposed to a high temperature environment under a state of large fastening torque, "galling" which is an adhering phenomenon occurs. However, fastening torque is small in the present invention, so that "galling" does not occur and a probability of a problem occurring at a time of detachment is reduced. Also, a dry lubricant becomes unnecessary.

Because of small fastening torque, by loosening the screw 43, it is possible to easily detach the consumed raw-material block 28 from the raw-material supporting unit 26. After detachment, a new raw-material block 28 can be easily attached to the raw-material supporting unit 26. In this manner, it is easy to replace the raw-material block 28.

### Reference Signs List

- 1: ION IMPLANTATION APPARATUS
- 10: ION SOURCE
- 12: GAS SUPPLY UNIT
- 20: FILAMENT
- 21: CHAMBER
- 22: CATHODE ELECTRODE
- 23: REPELLER ELECTRODE
- 26: RAW-MATERIAL SUPPORTING UNIT
- 28: RAW-MATERIAL BLOCK
- 38: ELECTRON EMITTING SURFACE

## Claims

1. An ion source (10) comprising:
a cathode electrode (22) arranged in one end of an inside of a chamber (21);
a repeller electrode (23) arranged in the other end of the inside of the chamber (21) and facing a surface of the cathode electrode (22);
a filament (20) arranged on a back-surface side of the cathode electrode (22);
a gas introduction hole (34) to which a fluorine-compound gas is introduced, the gas introduction hole (34) being provided in the chamber (21); and
an emission hole (35) through which a positively-charged ion is extracted out of the chamber (21), wherein
a raw-material block (28) is arranged in the chamber (21),
the cathode electrode(22) is heated by the filament(20) through which a current is flowing, and a thermoelectron is emitted from an electron emitting surface (38) of the surface of the cathode electrode(22) toward the repeller electrode(23), the thermoelectron decomposing the fluorine-compound gas introduced through the gas introduction hole(34) and generating plasma by reciprocally moving between the cathode electrode(22) and the repeller (23) electrode, and the positively-charged aluminum ion is generated by reaction of fluorine in the plasma with the raw-material block (28),
the raw-material block (28) is arranged near a side surface of the cathode electrode (22) while being out of contact with the cathode electrode (22) and the chamber (21),
the raw-material block (28) is aluminum nitride, and
aluminum fluoride that is generated from the raw-material block (28) and the fluorine-compound gas is decomposed by the thermoelectron so that an aluminum ion that is to be extracted out of the chamber (21) is generated,
**characterized in that**
the fluorine-compound gas is a phosphorus-trifluoride gas, the raw-material block (28) is arranged in a tip end of a raw-material supporting unit (26), a protruding portion (46) that protrudes in an outward direction that is perpendicular to a side surface of the raw-material supporting unit (26) is provided in the tip end of the raw-material supporting unit (26), the raw-material block (28) is arranged on a surface of the protruding portion (46), the surface of the protruding portion (46) facing the repeller electrode (23), and an attaching member (44) is arranged on a back surface of the protruding portion (46), and
the raw-material block (28) is hung from the attaching member(44) with screws (43), and the protruding portion (46) is pinched between the raw-material block (28) and the attaching member(44) so that the raw-material block (28) is fixed to the raw-material supporting unit (26).

2. The ion source (10) according to claim 1, wherein
the fluorine-compound gas is converted into the plasma by the thermoelectron, and
an evaporation surface (37) of the raw-material block (28), which is facing the repeller electrode(23) and contacts the plasma, is located between a surface of the repeller electrode(23) which is facing the cathode electrode(22) and the electron emitting surface (38), and is located in such a position that a distance between a flat surface in which the evaporation surface (37) is included and the electron emitting surface (38) is smaller than a distance between the flat surface that includes the evaporation surface (37) and a surface of the repeller electrode(23), the surface of the repeller electrode(23) facing the electron emitting surface (38) .

3. The ion source (10) according to claim 1, wherein the raw-material block (28) is heated to a temperature in a range of 1200 °c to 1700 °c, by heat generation of the cathode electrode (22) .

4. An ion implantation apparatus (1) comprising an ion source (10), according to one of the claims 1 to 3,
the ion implantation apparatus (1) further comprising:
an extraction electrode (24) arranged adjacent to the emission hole (35), the extraction electrode (24) being configured to extract the positively-charged ion in the chamber (21);
a mass spectrometer (3) configured to mass-analyze the ion extracted by the extraction electrode (24); and
an implantation chamber (6) in which a substrate (8) being irradiated with the ion that is mass-analyzed is arranged.

## Patentansprüche

1. Eine lonenquelle (10), aufweisend:
eine Kathodenelektrode (22), die an einem Ende einer Innenseite einer Kammer (21) angeordnet ist;
eine Abstoßungselektrode (23), die am anderen Ende der Innenseite der Kammer (21) angeordnet ist und einer Oberfläche der Kathodenelektrode (22) gegenüberliegt;
einen Glühfaden (20), der auf einer Rückseite der Kathodenelektrode (22) angeordnet ist;
eine Gaseinführungsöffnung (34), in die ein Gas mit einer Fluorverbindung eingeführt wird, wobei die Gaseinführungsöffnung (34) in der Kammer (21) vorgesehen ist; und
eine Emissionöffnung (35), durch die ein positiv geladenes Ion aus der Kammer (21) extrahiert wird, wobei
in der Kammer (21) ein Rohmaterialblock (28) angeordnet ist,
die Kathodenelektrode (22) durch den stromdurchflossenen Glühfaden (20) erhitzt wird, und ein Thermoelektron von einer elektronenemittierenden Oberfläche (38) der Oberfläche der Kathodenelektrode (22) in Richtung Abstoßungselektrode (23) emittiert wird, das Thermoelektron das über die Gaseinführungsöffnung (34) eingeleitete Gas mit einer Fluorverbindung zersetzt und, indem es sich zwischen der Kathodenelektrode (22) und der Abstoßungselektrode (23) hin- und herbewegt, ein Plasma erzeugt, wobei durch Reaktion von Fluor im Plasma mit dem Rohmaterialblock (28) das positiv geladene Aluminiumion erzeugt wird,
der Rohmaterialblock (28) in der Nähe einer Seitenfläche der Kathodenelektrode (22) angeordnet ist, wobei er mit der Kathodenelektrode (22) und der Kammer (21) nicht in Kontakt steht,
der Rohmaterialblock (28) aus Aluminiumnitrid besteht, und
aus dem Rohmaterialblock (28) und dem Gas mit der Fluorverbindung erzeugtes Aluminiumfluorid durch das Thermoelektron zersetzt wird, so dass ein aus der Kammer (21) zu extrahierendes Aluminiumion erzeugt wird,
**dadurch gekennzeichnet, dass**
das Gas mit der Fluorverbindung ein Phosphortrifluorid-Gas ist, der Rohmaterialblock (28) an einer Stirnseite einer Rohmaterialträgereinheit (26) angeordnet ist, ein vorstehender Abschnitt (46), der in einer nach außen gerichteten, senkrecht zu einer Seitenfläche der Rohmaterialträgereinheit (26) stehenden Richtung vorsteht, an der Stirnseite der Rohmaterialträgereinheit (26) vorgesehen ist, der Rohmaterialblock (28) auf einer Oberfläche des vorstehenden Abschnitts (46) angeordnet ist, wobei die Oberfläche des vorstehenden Abschnitts (46) der Abstoßungselektrode (23) zugewandt ist, und auf einer rückseitigen Oberfläche des vorstehenden Abschnitts (46) ein Befestigungselement (44) angeordnet ist, und
der Rohmaterialblock (28) mit Schrauben (43) an dem Befestigungselement (44) aufgehängt ist und der vorstehende Abschnitt (46) zwischen dem Rohmaterialblock (28) und dem Befestigungselement (44) eingeklemmt ist, so dass der Rohmaterialblock (28) an der Rohmaterialträgereinheit (26) befestigt ist.

2. Die lonenquelle (10) nach Anspruch 1, wobei
das Gas mit der Fluorverbindung durch das Thermoelektron in das Plasma umgewandelt wird, und
zwischen einer der Kathodenelektrode (22) und der Elektronenemissionsfläche (38) zugewandten Oberfläche der Abstoßungselektrode (23) eine der Abstoßungselektrode (23) zugewandte und mit dem Plasma in Kontakt stehende Verdampfungsfläche (37) des Rohmaterialblocks (28) angeordnet ist, und zwar in einer solchen Position angeordnet ist, dass ein Abstand zwischen einer die Verdampfungsoberfläche (37) enthaltenden flachen Oberfläche und der elektronenemittierenden Oberfläche (38) kleiner ist als ein Abstand zwischen der die Verdampfungsoberfläche (37) enthaltenden flachen Oberfläche und einer Oberfläche der Abstoßungselektrode (23), wobei die Oberfläche der Abstoßungselektrode (23) der elektronenemittierenden Oberfläche (38) gegenüberliegt.

3. Die lonenquelle (10) nach Anspruch 1, wobei der Rohmaterialblock (28) durch Wärmeerzeugung über die Kathodenelektrode (22) auf eine Temperatur in einem Bereich von 1200 °C bis 1700 °C erhitzt wird.

4. Eine lonenimplantationsvorrichtung (1) mit einer lonenquelle (10) nach einem der Ansprüche 1 bis 3,
wobei die lonenimplantationsvorrichtung (1) ferner aufweist:
eine Extraktionselektrode (24), die angrenzend an die Emissionsöffnung (35) angeordnet ist, wobei die Extraktionselektrode (24) so ausgebildet ist, dass sie das positiv geladene Ion aus der Kammer (21) extrahiert;
ein Massenspektrometer (3), das so ausgebildet ist, dass es das durch die Extraktionselektrode (24) extrahierte Ion einer Massenanalyse unterzieht; und
eine Implantationskammer (6), in der ein Substrat (8) angeordnet ist, das mit dem massenanalysierten Ion bestrahlt wird.

## Revendications

1. Source d'ions (10) comprenant :
une électrode de cathode (22) agencée dans une extrémité de l'intérieur d'une chambre (21) ;
une électrode de répulsion (23) agencée dans l'autre extrémité de l'intérieur de la chambre (21) et faisant face à une surface de l'électrode de cathode (22) ;
un filament (20) agencé sur un côté de surface arrière de l'électrode de cathode (22) ;
un trou d'introduction de gaz (34) dans lequel est introduit un composé fluoré gazeux, le trou d'introduction de gaz (34) étant ménagé dans la chambre (21) ; et
un trou d'émission (35) par lequel un ion chargé positivement est extrait de la chambre (21), dans lequel
un bloc de matière première (28) est agencé dans la chambre (21),
l'électrode de cathode (22) est chauffée par le filament (20) à travers lequel circule un courant, et un thermoélectron est émis à partir d'une surface émettrice d'électrons (38) de la surface de l'électrode de cathode (22) vers l'électrode de répulsion (23), le thermoélectron décomposant le composé fluoré gazeux introduit à travers le trou d'introduction de gaz (34) et générant un plasma en se déplaçant d'un mouvement de va-et-vient entre l'électrode de cathode (22) et l'électrode de répulsion (23), et l'ion aluminium chargé positivement est généré par réaction du fluor dans le plasma avec le bloc de matière première (28),
le bloc de matière première (28) est agencé à proximité d'une surface latérale de l'électrode de cathode (22) tout en étant hors de contact avec l'électrode de cathode (22) et la chambre (21),
le bloc de matière première (28) est du nitrure d'aluminium, et
le fluorure d'aluminium qui est généré par le bloc de matière première (28) et le composé fluoré gazeux est décomposé par le thermoélectron de sorte qu'un ion d'aluminium à extraire de la chambre (21) soit généré, **caractérisé en ce que**
le composé fluoré gazeux est le gaz trifluorure de phosphore, le bloc de matière première (28) est agencé dans une extrémité d'une unité de support de matière première (26), une partie saillante (46) qui fait saillie dans une direction vers l'extérieur qui est perpendiculaire à une surface latérale de l'unité de support de matière première (26) est fournie dans l'extrémité de l'unité de support de matière première (26), le bloc de matière première (28) est agencé sur une surface de la partie saillante (46), la surface de la partie saillante (46) faisant face à l'électrode de répulsion (23), et un élément de fixation (44) est agencé sur une surface arrière de la partie saillante (46), et
le bloc de matière première (28) est suspendu à l'élément de fixation (44) à l'aide de vis (43), et la partie saillante (46) est pincée entre le bloc de matière première (28) et l'élément de fixation (44) de sorte que le bloc de matière première (28) soit fixé à l'unité de support de matière première (26).

2. Source d'ions (10) selon la revendication 1, dans laquelle
le composé fluoré gazeux est converti en plasma par le thermoélectron, et
une surface d'évaporation (37) du bloc de matière première (28), qui fait face à l'électrode de répulsion (23) et entre en contact avec le plasma, est située entre une surface de l'électrode de répulsion (23) qui fait face à l'électrode de cathode (22) et la surface émettrice d'électrons (38), et est située dans une telle position qu'une distance entre une surface plate dans laquelle est incluse la surface d'évaporation (37) et la surface émettrice d'électrons (38) est inférieure à une distance entre la surface plate qui inclut la surface d'évaporation (37) et une surface de l'électrode de répulsion (23), la surface de l'électrode de répulsion (23) faisant face à la surface émettrice d'électrons (38).

3. Source d'ions (10) selon la revendication 1, dans laquelle le bloc de matière première (28) est chauffé à une température dans une plage de 1 200 °C à 1 700 °C, par génération de chaleur de l'électrode de cathode (22) .

4. Appareil d'implantation ionique (1) comprenant une source d'ions (10), selon l'une des revendications 1 à 3, l'appareil d'implantation ionique (1) comprenant en outre :
une électrode d'extraction (24) agencée à côté du trou d'émission (35), l'électrode d'extraction (24) étant configurée pour extraire l'ion chargé positivement dans la chambre (21) ;
un spectromètre de masse (3) configuré pour réaliser une analyse de masse de l'ion extrait par l'électrode d'extraction (24) ; et
une chambre d'implantation (6) dans laquelle est agencé un substrat (8) étant irradié avec l'ion sur lequel a été réalisée l'analyse de masse.
